# EUROPÄISCHE PATENTANMELDUNG

(11) **EP 4 053 919 A1**
(43) Veröffentlichungstag der Anmeldung: **07.09.2022**
(21) Anmeldenummer: 22000040.0
(22) Anmeldetag: 01.03.2022
(51) Int. Cl.: H01L 31/0224, H01L 31/18, H01L 31/0687

(54) **VERFAHREN ZUM DURCHKONTAKTIEREN**

(30) Priorität: 02.03.2021 DE 102021001116
(71) Anmelder: AZUR SPACE Solar Power GmbH, 74072 Heilbronn (DE)
(72) Erfinder: Köstler, Wolfgang, 74074 Heilbronn (DE); Kubera, Tim, 74211 Leingarten (DE)
(74) Vertreter: Koch Müller Patentanwaltsgesellschaft mbH

(57) **Zusammenfassung**

Verfahren zum Durchkontaktieren mittels einer Durchgangsöffnung auf einer Halbleiterscheibe mindestens umfassend die Schritte, Bereitstellen einer Halbleiterscheibe mit einer Oberseite, einer Unterseite, wobei die Halbleiterscheibe mehrere Solarzellenstapel aufweist und an der Unterseite ein Substrat umfasst, und jeder Solarzellenstapel mindestens zwei auf dem Substrat angeordnete III-V-Teilzellen und mindestens eine von der Oberseite bis zu der Unterseite der Halbleiterscheibe reichende Durchgangsöffnung mit zusammenhängender Seitenwand aufweist, wobei die Durchgangsöffnung an der Oberseite einen ersten Randbereich und an der Unterseite einen zweiten Randbereich aufweist, Aufbringen einer Isolationsschicht auf einen Teil des ersten Randbereichs, der Seitenwand und auf den zweiten Randbereich mittels eines ersten Druckverfahrens, Aufbringen einer elektrisch leitfähigen Schicht mittels eines zweiten Druckverfahrens auf die Isolationsschicht auf der Oberseite und einen Teil des ersten Randbereichs, auf die Isolationsschicht an der Seitenwand und auf einen Teil der Isolationsschicht an der Unterseite.

## Beschreibung

Die Erfindung betrifft ein Verfahren zum Durchkontaktieren.

Um die Abschattung der Vorderseite einer Solarzelle zu reduzieren, ist es möglich, sowohl die positive als auch die negative externe Kontaktfläche auf der Rückseite anzuordnen. Bei sogenannten Metal Wrap Through (MWT) - Solarzellen wird die Solarzellenvorderseite beispielsweise durch eine Durchgangskontaktöffnung von der Rückseite aus kontaktiert.

Es sind unterschiedliche Verfahren zur Herstellung eines Lochs bzw. einer Durchgangskontaktöffnung durch eine Solarzelle bekannt. Die durch die Durchgangsöffnung verlaufende Metallisierung wird mittels einer Isolationsschicht gegenüber den Schichten des Solarzellenstapels isoliert.

Beispielsweise Ist aus der US 9,680,035 B1 ein Solarzellenstapel aus mehreren III-V-Teilzellen auf einem GaAs-Substrat mit rückseltenkontaktierter Vorderseite bekannt, wobei ein von der Oberseite der Solarzelle durch die Teilzellen bis in eine noch nicht gedünnte Substratschicht hineinreichendes Loch mittels eines nasschemischen Ätzprozesses erzeugt wird. Der Ätzprozess basiert darauf, dass sich die Ätzraten zumindest für die verwendeten unterschiedlichen III-V-Materialien des Solarzellenstapels nicht wesentlich unterscheiden. Eine Passivierung und Metallisierung der Vorderseite und des Lochs wird vor dem Dünnen der Substratschicht durchgeführt.

Vor diesem Hintergrund besteht die Aufgabe der Erfindung darin, eine Vorrichtung anzugeben, die den Stand der Technik weiterbildet.

Die Aufgabe wird durch ein Verfahren mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Verfahren zum Durchkontaktieren einer Halbleiterscheibe bereitgestellt, wobei das Verfahren mehrere Schritte umfasst.

In einem ersten Prozessschritt wird bei einer Halbleiterscheibe bereitgestellt mit einer Oberseite und einer Unterseite, wobei die Halbleiterscheibe mehrere Solarzellenstapel aufweist und an der Unterseite ein Substrat umfasst.

Jeder Solarzellenstapel weist mindestens zwei auf dem Substrat angeordnete III-V-Teilzellen und mindestens eine von der Oberseite bis zu der Unterseite der Halbleiterscheibe reichende Durchgangsöffnung mit zusammenhängender Seitenwand auf. Die Durchgangsöffnung weist an der Oberseite einen ersten Randbereich und an der Unterseite einen zweiten Randbereich auf.

In einem zweiten Prozessschritt wird mittels eines ersten Druckverfahrens eine Isolationsschicht auf einen Teil des ersten Randbereichs, der Seitenwand und auf den zweiten Randbereich aufgebracht.

In einem dritten Prozessschritt wir mittels eines zweiten Druckverfahrens eine elektrisch leitfähige Schicht auf die Isolationsschicht auf der Oberseite und einen Teil des ersten Randbereichs, auf die Isolationsschicht an der Seitenwand und auf einen Teil der Isolationsschicht an der Unterseite aufgebracht.

Es versteht sich, dass die Prozessschritte in der genannten Reihenfolge ausgeführt werden.

Es sei angemerkt, dass mit dem Begriff "Isolationsschicht" insbesondere auch ein die Isolationsschicht umfassendes dielektrisches Schichtsystem verstanden wird. Des Weiteren wird mit dem Begriff Randbereich jeweils ein unmittelbar an die Durchgangsöffnung angeordneter Bereich auf der Oberseite und auf der Unterseite bezeichnet.

Es sei angemerkt, dass eine Einstrahlung von Licht auf die Oberseite erfolgt. Um möglichst wenig von der Oberseite abzuschatten ist die Oberseite mittels einer metallischen Fingerstruktur elektrisch angeschlossen.

Vorzugsweise nimmt die Bandlücke der von der Oberseite in Richtung des Substrats von Teilzelle zu Teilzelle ab. Im Allgemeinen weisen die Teilzellen des jeweiligen Solarzellenstapels eine n auf p Anordnung aus. Es versteht sich, dass zwischen zwei Teilzellen jeweils eine Tunneldiode ausgebildet ist, um die einzelnen Teilzelle aus elektrischer Sicht in Serie zu verschalten. Insbesondere umfasst die oberste Teilzelle eine Verbindung aus InGaP und weist eine Bandlücke größer als 1,7 eV auf.

Es versteht sich, dass auf der Oberseite eine im Allgemeinen fingerförmig ausgeführte Oberseitenmetallisierung angeordnet ist, um die Vorderseite elektrisch anzuschließen. Nachfolgend wird die Oberseitenmetallisierung auch als Metallstruktur bezeichnet.

Es sei angemerkt, dass die Durchgangsöffnung vorzugsweise oval ausgebildet ist. Vorliegend sind mit dem Begriff "oval" auch runde insbesondere kreisförmige, eiförmige und elliptische Formen umfasst. In einer anderen Ausführungsform ist die Durchgangsöffnung als viereckige Form mit abgerundeten Ecken ausgebildet. Es versteht sich das bei jedem Solarzellenstapel mittels einer oder mehrere Durchgangsöffnungen die Vorderseite von der Rückseite elektrisch angeschlossen wird.

Vorzugsweise wird vor der Ausbildung der Durchgangsöffnung die Halbleiterscheibe, die im Allgemeinen einen Durchmesser von 100 mm oder 150 mm aufweist, auf die gewünschte Enddicke gedünnt. Hierzu wird auf der Rückseite Substrat-Material abgetragen.

Des Weiteren sei angemerkt, dass die Halbleiterscheibe mehrere nicht vereinzelte Solarzellenstapel aufweist, wobei das Substrat die Unterseite der Halbleiterscheibe ausbildet. Es versteht sich, dass der Solarzellenstapel auch 3 oder 4 oder 5 oder maximal 6 Teilzellen aufweist.

Ein Vorteil des Verfahrens besteht darin, dass mittels des mehrfachen strukturierten Aufbringens mittels eines Druckverfahrens, d.h. von der Isolationsschicht als auch von der Metallschicht, photolithographische Prozessschritte vermieden werden. Insbesondere werden die verbundenen Prozessunsicherheiten bei einem Aufbringen einer Lackschicht bei großen Topographie vermieden. Die Ausbildung der Durchkontaktierung, d.h. die Ausbildung eines elektrischen Anschlusses der Vorderseite von der Rückseite vereinfacht den elektrischen Anschluss des Solarzellenstapels. benötigt und ein zuverlässiger Schutz der Isolationsschicht im Bereich der Durchgangsöffnung ausgebildet wird.

Insbesondere sind der zeitliche und technische Aufwand sowie der Materialverbrauch im Vergleich zum Stand der Technik gering. Ein weiterer Vorteil ist, dass die Zuverlässigkeit und die Ausbeute erhöht werden.

Anders ausgedrückt, die Durchgangsöffnung und die an die Durchgangsöffnung angrenzenden Bereiche werden auf der Oberseite und auf der Unterseite werden ausschließlich mittels des Druckverfahrens bedeckt. Mit dem Verfahren lassen sich auf einfache und kostengünstige Weise hocheffiziente und zuverlässige Mehrfach-Solarzellen herstellen, deren Vorderseite elektrisch an der Rückseite angeschlossen ist.

In einer Weiterbildung wird nach dem ersten Druckverfahren und vor der Durchführung des zweiten Druckverfahrens ein erster Ausheizschritt durchgeführt. In einer anderen Weiterbildung wird nach dem zweiten Druckverfahren ein zweiter Ausheizschritt durchgeführt. Mittels den Ausheizschritten werden die Isolationsschicht und die leitfähige Schicht jeweils konditioniert. Vorzugsweise werden die Ausheizschritte in einem Temperaturbereich zwischen 100°C und 450°C durchgeführt.

In einer Weiterbildung wird zur Ausbildung der Isolationsschicht eine Paste verwendet wird. Vorzugsweise umfasst die Paste organische Bestandteile.

In einer anderen Weiterbildung wird zur Ausbildung der leitfähigen Schicht eine Metallpartikel enthaltene Paste verwendet.

In einer Ausführungsform wird das erste Druckverfahren und / oder das zweite Druckverfahren ausschließlich von der Vorderseite oder ausschließlich von der Rückseite durchgeführt. Alternativ wird das erste Druckverfahren und / oder das zweite Druckverfahren sowohl von der Vorderseite als auch von der Rückseite durchgeführt.

In einer anderen Ausführungsform weist die Durchgangsöffnung nach der Ausbildung der Isolationsschicht noch ein durchgehendes Loch auf. Alternativ wird die Durchgangsöffnung mittels eines Lasers in einem zentralen Bereich geöffnet.

In einer Weiterbildung ist nach der Ausbildung der leitfähigen Schicht die Durchgangsöffnung teilweise oder vollständig geschlossen. Alternativ weist die Durchgangsöffnung nach der Ausbildung der leitfähigen Schicht noch ein durchgehendes Loch auf.

Vorzugsweise besteht die leitfähige Schicht auf dem ersten Randbereich und in der Durchgangsöffnung und auf dem zweiten Randbereich aus dem gleichen Material. In einer alternativen Ausführungsform werden zur Ausbildung der leitfähigen Schicht auf der Oberseite und auf der Unterseite unterschiedliche Zusammensetzungen verwendet.

Sofern die Durchgangsöffnung mittels der leitfähigen Schicht vollständig geschlossen ist, steht in einer Weiterbildung die leitfähige Schicht über die Oberseite und / oder an der Unterseite hinaus. Alternativ bildet die leitfähige Schicht an der Unterseite auf der Isolationsschicht mit der leitfähigen Schicht in dem Zentrum der Durchgangsöffnung eine in einer ersten Näherung planen Fläche aus.

In einer Ausführungsform weist der erste Randbereich an der Oberseite einen anderen, insbesondere kleineren Durchmesser als der zweite Randbereich an der Unterseite auf.

In einer anderen Ausführungsform sind der erste Randbereich und der zweite Randbereich jeweils als ein vollständig um die Durchgangsöffnung umlaufender Randbereich ausgebildet. Vorzugsweise weist der jeweilige Randbereich parallel zur Halbleiterscheibe einen Durchmesser von wenigstens 10 µm und höchstens 3,0 mm auf. Alternativ weist der jeweilige Randbereich parallel zur Halbleiterscheibe einen Durchmesser von wenigstens 100 µm und höchstens 1,0 mm auf.

In einer Weiterbildung wird das Druckverfahren mittels ein Inkjet-Verfahrens oder einem Siebdruckverfahren oder mittels einem ein Dispens-Verfahren durchgeführt. Alternativ wird das Druckverfahren mittels eines Schablonendruckverfahrens durchgeführt. In einer anderen Weiterbildung werden wenigstens zwei der unterschiedlichen Druckverfahren kombiniert.

In einer anderen Weiterbildung weist die Durchgangsöffnung der Halbleiterscheibe eine Gesamthöhe von höchstens 500 µm und von mindestens 30 µm oder von höchstens 200 µm und von mindestens 50 µm auf.

In einer Ausführungsform weist die Durchgangsöffnung im Querschnitt einen ovalen Umfang, insbesondere einen runden Umfang auf. Vorzugsweise weist die Durchgangsöffnung vor der Anwendung des ersten Druckverfahrens einen Durchmesser zwischen 25 µm und 1 mm auf. Alternativ liegt der Durchmesser in einem Bereich zwischen 50 µm bis 300 µm.

In einer Weiterbildung ist der Durchmesser der Durchgangsöffnung vor der Anwendung des ersten Druckverfahrens in dem Substrat von Richtung Oberseite aus hin zur Unterseite in erster Näherung oder genau gleich. Alternativ wird der Durchmesser der Durchgangsöffnung von der Oberseite in Richtung zu der Unterseite kleiner, wobei die Verjüngung vorzugsweise stufenmäßig ausgebildet ist. In einer Weiterbildung weist die Durchgangsöffnung eine sanduhrförmige Ansicht in einem Querschnitt auf. Hierbei verjüngt sich der Querschnitte bis etwa zur Hälfte der Gesamtdicke.

In einer anderen Weiterbildung umfasst die Verjüngung genau eine in der Durchgangsöffnung oder genau zwei vollständig umlaufende Stufen.

In einer anderen Weiterbildung ist das Substrat elektrisch leitfähig ausgebildet. Vorzugsweise umfasst das Substrat Germanium oder GaAs oder Silizium oder besteht aus einen der vorgenannten Materialien. Alternativ umfasst das Substrat eine Metallfolie oder umfasst einen elektrisch leitfähigen Kunststoff.

Vorzugsweise weist die Halbleiterscheibe oder das Substrat eine Größe von 100 mm oder 150 mm oder größer auf.

Umfasst oder besteht das Substrat aus Germanium bildet das Ge-Substrat die Unterseite der Halbleiterscheibe aus. Vorzugsweise ist in dem Ge-Substrat auf der von der Unterseite abgewandten Seite eine erste Teilzelle als Ge-Teilzelle ausgebildet, wobei die Ge-Teilzelle die kleinste Bandlücke der Teilzellen des Solarzellenstapels aufweist.

Bei der Verwendung von Ge als Substrat ist eine erste Stufe an der Grenzfläche zwischen Ge-Teilzelle und den aufliegenden III-V Teilzellen ausgebildet. Eine zweite Stufe ist vorzugsweise zwischen der Ge-Teilzelle und dem Ge-Substrat ausgebildet.

Vorzugsweise verjüngt sich die Durchgangsöffnung auch innerhalb des Ge-Substrats. Die stufenförmige bzw. konische Ausführung der Durchgangsöffnung hat den Vorteil, dass sich insbesondere bei einer vorzugsweise konformen Abscheidung der Isolationsschicht und / oder weiteren aufzubringenden Schichten im Rahmen einer Metallisierung die Dicke der Schichten sind auf den Seitenflächen hinreichend ausbilden lässt.

In einer Weiterbildung ist eine weitere Stufe an der Oberseite der Halbleiterscheibe an der Grenzfläche zwischen Metallstruktur und der Oberseite der obersten III-V Teilzelle ausgebildet.

In einer Ausführungsform weist der Solarzellenstapel eine Ge-Teilzelle auf. In Folge umfasst der Solarzellenstapel wenigstens 3 Teilzellen.

In einer anderen Ausführungsform wird ein Teil der Isolationsschicht auf der Oberseite auf einer Metallfläche ausgebildet. Hierdurch lässt sich sicherstellen, dass auf der Oberseite die Metallstruktur, d.h. die Vorderseite des Solarzellenstapels angeschlossen wird.

Anders ausgedrückt, indem die leitfähige Schicht auf der Oberseite die Isolationsschicht übergreift und eine stoffschlüssige Verbindung mit einem Teil der Metallstruktur ausbildet und auf der Unterseite jedoch nur den unmittelbar an die Durchgangsöffnung angrenzenden Teil des zweiten Randbereichs bedeckt, wird hierdurch an der Unterseite einen Kontaktbereich für einen elektrischen Anschluss der Metallstruktur MV ausgebildet.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die laterale und die vertikale Erstreckung sind nicht maßstäblich und weisen, sofern nicht anders angegeben, auch keine ableitbaren geometrischen Relationen zueinander auf. Darin zeigen, die
- Figur 1: einen Querschnittsansicht einer metallisierten Durch-gangsöffnung in einer Ausführungsform,
- Figur 2: einen Querschnittsansicht einer metallisierten Durch-gangsöffnung in einer weiteren Ausführungsform,
- Figur 3: einen Querschnittsansicht einer metallisierten Durch-gangsöffnung in einer anderen Ausführungsform,
- Figur 4a: eine Draufsicht auf die Oberseite der metallisierten Durch-gangsöffnung entsprechend der Ausführungsform, darge-stellt in Zusammenhang mit der Abbildung der Figur 3,
- Figur 4b: eine Draufsicht auf die Unterseite der metallisierten Durchgangsöffnung entsprechend der Ausführungsform, dargestellt in Zusammenhang mit der Abbildung der Figur 3,
- Figur 5: eine Draufsicht auf eine Halbleiterscheibe mit zwei Solar-zellenstapel.

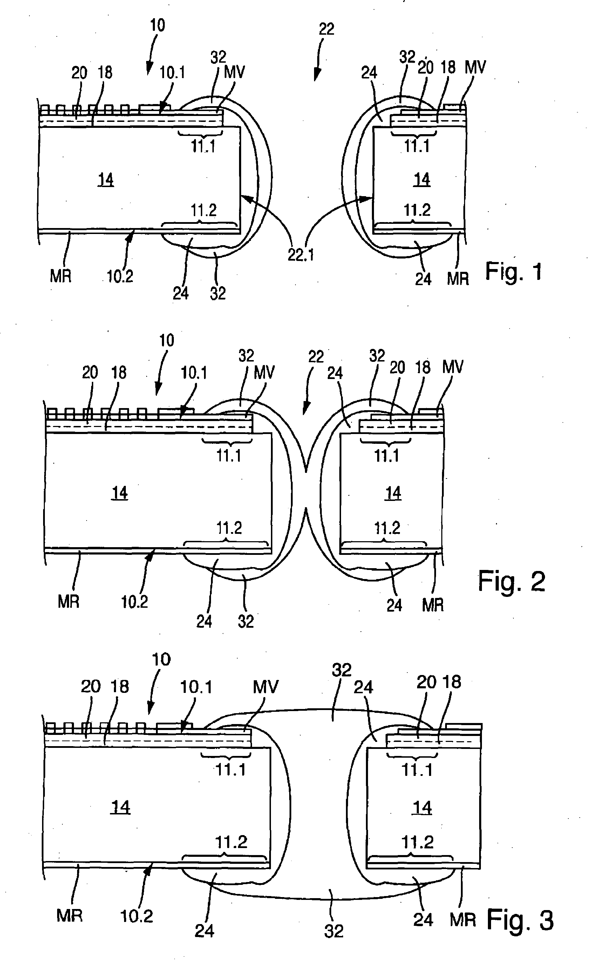

Die Abbildungen der Figur 1 zeigt Querschnittsansicht einer metallisierten Durchgangsöffnung 22 einer Halbleiterscheibe 10.

Es wird eine Halbleiterscheibe 10 mit einer Oberseite 10.1, einer Unterseite 10.2 und einer von der Oberseite 10.1 bis zu der Unterseite 10.2 erstreckenden Durchgangsöffnung 22 mit einer zusammenhängenden Seitenwand 22.1 bereitgestellt.

Die Halbleiterscheibe 10 umfasst mehrere noch nicht vereinzelte Solarzellenstapel 12, dargestellt ist vorliegend nur ein Solarzellenstapel 12, jeweils mit einer Schichtfolge aus einem die Unterseite 10.2 ausbildenden Substrat 14, einer ersten III-V-Teilzelle 18 und einer die Oberseite 10.1 ausbildenden zweiten III-V-Teilzelle 20.

Auf der Oberseite 10.1 ist eine Metallstruktur MV ausgebildet. Die Metallstruktur MV ist fast ausschließlich als fingerförmige Struktur ausgebildet und weist insbesondere in dem ersten Randbereich 11.1 der Durchgangsöffnung 22 eine um vollständig um die Durchgangsöffnung 22 ausgebildete zusammenhängende Metallfläche aus.

Auf der Unterseite 10.2 ist eine ganzflächige Rückseitenmetallisierung MR ausgebildet, um das leitfähige Substrat 14 anzuschließen. Es versteht sich das mit den beiden Metallisierungen MV und MR der jeweilige Solarzellenstapel 12 elektrisch angeschlossen wird.

Die Durchgangsöffnung 22 weist an der Oberseite 10.1 einen ersten Randbereich 11.1 und an der Unterseite 10.2 einen zweiten Randbereich 11.2 auf. Der erste Randbereich 11.1 ist unmittelbar auf der Metallstruktur MV und der zweite Randbereich 11.2 ist unmittelbar auf der Rückseitenmetallisierung MR ausgebildet.

Ein unmittelbar um die Durchgangsöffnung 22 ausgebildeter Teil des ersten Randbereichs 11.1. und der gesamte zweite Randbereich 11.2 sowie die Seitenwand 22.1 der Durchgangsöffnung 22 sind mit einer Isolationsschicht 24 beschichtet, wobei die Isolationsschicht 24 mit einem ersten Druckverfahren ausgebildet wird. Es versteht sich, dass die Seitenwand 22.1 in der Durchgangsöffnung 22 vollständig von der Isolationsschicht 24 bedeckt ist.

Mittels eines zweiten Druckverfahrens wird eine leitfähige Schicht 32 auf das gesamte Gebiet des ersten Randbereich 11.1 und vollständig auf die gesamte Fläche der Seitenwand 22.1 und auf unmittelbar einen an die Durchgangsöffnung 22 angrenzenden Teil des zweiten Randbereich 11.2 aufgebracht. Vorliegend ist die Durchgangsöffnung 22 auch nach der Ausbildung der leitfähigen Schicht 32 noch offen.

Indem die leitfähige Schicht 32 auf der Oberseite 10.1 die Isolationsschicht 24 übergreift und eine stoffschlüssige Verbindung mit einem Teil der Metallstruktur MV ausbildet und auf der Unterseite 10.2 jedoch nur den unmittelbar an die Durchgangsöffnung 22 angrenzenden Teil des zweiten Randbereich 11.2 bedeckt, wird hierdurch an der Unterseite 10.2 einen Kontaktbereich für einen Anschluss der Metallstruktur MV ausgebildet.

In der Abbildung der Figur 2 ist eine weitere Ausführungsform dargestellt. Im Folgenden werden nur die Unterschiede zu der Abbildung der Figur 1 erläutert.

In der dargestellten Ausführungsform stößt die leitfähige Schicht 32 in der Mitte des Substrats 14 zusammen und bildet ein Profil in Form einer Sanduhr aus.

In der Abbildung der Figur 3 ist eine andere Ausführungsform dargestellt. Im Folgenden werden nur die Unterschiede zu der Abbildung der Figur 1 erläutert.

In der dargestellten Ausführungsform wird die Durchgangsöffnung 22 vollständig von der leitfähigen Schicht 32 ausgefüllt und bildet eine aus Oberseite 10.1 und eine aus der Unterseite 10.2 hinausstehende Erhebung aus.

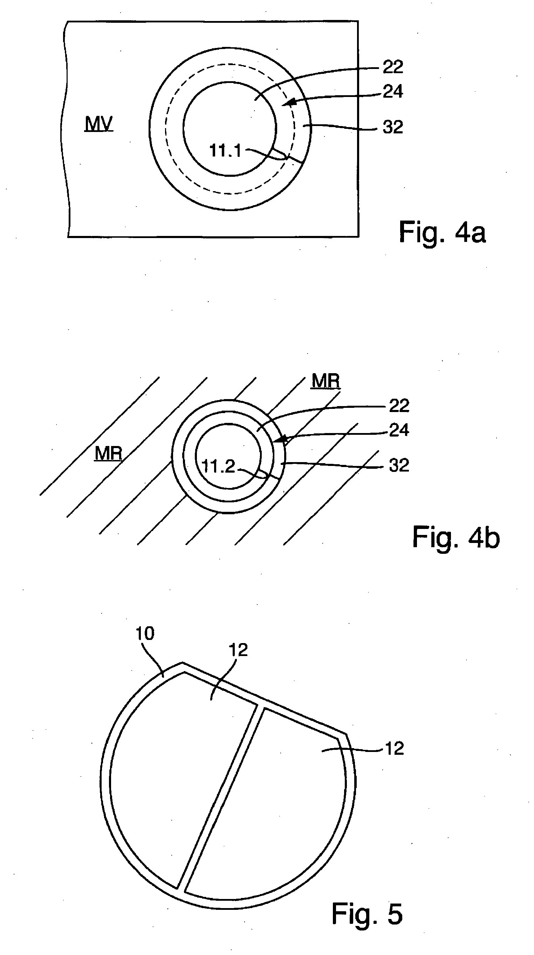

In der Abbildung der Figur 4a ist eine Draufsicht auf die Oberseite der metallisierten Durchgangsöffnung 22 entsprechend der Ausführungsform, dargestellt in Zusammenhang mit der Abbildung der Figur 3, abgebildet.

Der erste Randbereich 11.1, als Teil des Metallstruktur MV, umschließt die Durchgangsöffnung 22 vollständig. Der mit der Isolationsschicht 24 bedeckte Teil des ersten Randbereichs 11.1 ist gestrichelt eingezeichnet. Es zeigt sich, dass die leitfähige Schicht 22 die Isolationsschicht 24 auf der Oberseite 10.1 vollständig überdeckt.

In der Abbildung der Figur 4b ist eine Draufsicht auf die Unterseite der metallisierten Durchgangsöffnung 22 entsprechend der Ausführungsform, dargestellt in Zusammenhang mit der Abbildung der Figur 3, abgebildet.

Der zweite Randbereich 11.2, als Teil der Rückseitenmetallisierung MR, umschließt die Durchgangsöffnung 22 vollständig. Der mit der Isolationsschicht 24 bedeckte Teil des zweiten Randbereichs 11.2 ist nunmehr größer als der Teil bedeckt mit der leitfähigen Schicht 22. Anders ausgedrückt die leitfähige Schicht 22 überdeckt die Isolationsschicht 24 auf der Unterseite 10.2 nur teilweise.

In der Abbildung der Figur 5 ist eine Draufsicht auf eine Halbleiterscheibe 10 mit zwei Solarzellenstapel dargestellt. Vorliegend weist die Halbleiterscheibe 10 genau zwei Solarzellenstapel 12 auf. Es versteht sich, dass in nicht dargestellten Ausführungsformen auch mehr als zwei Solarzellenstapel 12 auf der Halbleiterscheibe 10 ausgebildet sind.

## Patentansprüche

1. Verfahren zum Durchkontaktieren mittels einer Durchgangsöffnung (22) bei einer Halbleiterscheibe (10) mindestens umfassend die Schritte:
- Bereitstellen einer Halbleiterscheibe (10) mit einer Oberseite (10.1), einer Unterseite (10.2), wobei die Halbleiterscheibe (10) mehrere Solarzellenstapel (12) aufweist und an der Unterseite ein Substrat (14) umfasst,
und jeder Solarzellenstapel (12) mindestens zwei auf dem Substrat (14) angeordnete III-V-Teilzellen (18, 20) und mindestens eine von der Oberseite (10.1) bis zu der Unterseite (10.2) der Halbleiterscheibe (10) reichende Durchgangsöffnung (22) mit zusammenhängender Seitenwand (22.1) aufweist, wobei die Durchgangsöffnung an der Oberseite (10.1) einen ersten Randbereich (11.1) und an der Unterseite (10.2) einen zweiten Randbereich (11.2) aufweist,
- Aufbringen einer Isolationsschicht (24) auf einen Teil des ersten Randbereichs (11.1), der Seitenwand (22.1) und auf den zweiten Randbereich (11.2) mittels eines ersten Druckverfahrens,
- Aufbringen einer elektrisch leitfähigen Schicht (32) mittels eines zweiten Druckverfahrens auf die Isolationsschicht (24) auf der Oberseite (10.1) und einen Teil des ersten Randbereichs (11.1), auf die Isolationsschicht (24) an der Seitenwand (22.1) und auf einen Teil der Isolationsschicht (24) an der Unterseite (10.2).

2. Verfahren nach Anspruch 1, **dadurch gekennzeichnet, dass** zur Ausbildung der Isolationsschicht (24) eine Paste verwendet wird und die Paste organische Bestandteile umfasst.

3. Verfahren nach Anspruch 1 oder Anspruch 2, **dadurch gekennzeichnet, dass** zur Ausbildung der leitfähigen Schicht (32) eine Metallpartikel enthaltene Paste verwendet wird.

4. Verfahren nach einem der vorstehenden Ansprüche, **dadurch gekennzeichnet, dass** das erste Druckverfahren und / oder das zweite Druckverfahren ausschließlich von der Vorderseite oder ausschließlich von der Rückseite durchgeführt wird.

5. Verfahren nach einem der vorstehenden Ansprüche, **dadurch gekennzeichnet, dass** nach der Ausbildung der Isolationsschicht (24) die Durchgangsöffnung (22) noch ein durchgehendes Loch aufweist.

6. Verfahren nach einem der vorstehenden Ansprüche, **dadurch gekennzeichnet, dass** nach der Ausbildung der leitfähigen Schicht (32) die . Durchgangsöffnung teilweise oder vollständig geschlossen ist oder die Durchgangsöffnung noch ein durchgehendes Loch aufweist.

7. Verfahren nach einem der vorstehenden Ansprüche, **dadurch gekennzeichnet, dass** erste Randbereich (11.1) einen anderen, insbesondere kleineren Durchmesser als der zweite Randbereich (11.2) aufweist.

8. Verfahren nach einem der vorstehenden Ansprüche, **dadurch gekennzeichnet, dass** der erste Randbereich (11.1) und der zweite Randbereich (11.2) jeweils als ein vollständig um die Durchgangsöffnung (22) umlaufender Randbereich ausgebildet ist und der jeweilige Randbereich (11.1, 11.2) parallel zur Halbleiterscheibe (10) einen Durchmesser von wenigstens 10 µm und höchstens 3,0 mm aufweist oder der jeweilige Randbereich parallel zur Halbleiterscheibe (10) einen Durchmesser von wenigstens 100 µm und höchstens 1,0 mm aufweist.

9. Verfahren nach einem der vorstehenden Ansprüche, **dadurch gekennzeichnet, dass** das Druckverfahren mittels eines Inkjet-Verfahrens oder mittels eines Siebdruckverfahrens oder mittels eines Dispens-Verfahrens oder mittels eines Schablonendruckverfahrens durchgeführt wird.

10. Verfahren nach einem der vorstehenden Ansprüche, **dadurch gekennzeichnet, dass** die Durchgangsöffnung (22) der Halbleiterscheibe (10) eine Gesamthöhe (H1) von höchstens 500 µm und von mindestens 30 µm aufweist oder von höchstens 200 µm und von mindestens 50 µm aufweist.

11. Verfahren nach einem der vorstehenden Ansprüche, **dadurch gekennzeichnet, dass** die Durchgangsöffnung (22) der Halbleiterscheibe (10) einem im Querschnitt ovalen Umfang, insbesondere einen runden Umfang aufweist.

12. Verfahren nach einem der vorstehenden Ansprüche, **dadurch gekennzeichnet, dass** die Durchgangsöffnung (22) vor der Anwendung des ersten Druckverfahrens einen Durchmesser zwischen 25 µm und 1 mm aufweist oder typisch 50µm bis 300 µm.

13. Verfahren nach einem der vorstehenden Ansprüche, **dadurch gekennzeichnet, dass** der Durchmesser der Durchgangsöffnung (22) in dem Substrat (14) von der Oberseite (10.1) in Richtung der Unterseite (10.2) in erster Näherung oder genau gleich ist.

14. Verfahren nach einem der vorstehenden Ansprüche, **dadurch gekennzeichnet, dass** das Substrat (14) elektrisch leitfähig ausgebildet ist und das Substrat Germanium oder GaAs oder Silizium umfasst oder aus einen der vorgenannten Materialien besteht oder das Substrat (14) eine Metallfolie oder einen elektrisch leitfähigen Kunststoff umfasst oder besteht.

15. Verfahren nach einem der vorstehenden Ansprüche, **dadurch gekennzeichnet, dass** der Solarzellenstapel eine Ge-Teilzelle (16) aufweist.

16. Verfahren nach einem der vorstehenden Ansprüche, **dadurch gekennzeichnet, dass** ein Teil der Isolationsschicht auf der Oberseite (10.1) auf einer Metallfläche ausgebildet wird.
